# EUROPÄISCHE PATENTANMELDUNG

(11) **EP 4 564 017 A1**
(43) Veröffentlichungstag der Anmeldung: **04.06.2025**
(21) Anmeldenummer: 23213236.5
(22) Anmeldetag: 30.11.2023
(51) Int. Cl.: G01R 19/25, G01R 31/00

(54) **VERBINDUNGSLEITER, ANORDNUNG MIT VERBINDUNGSLEITER UND VERWENDUNG EINES VERBINDUNGSLEITERS**

(71) Anmelder: Siemens Aktiengesellschaft, 80333 München (DE)
(72) Erfinder: Braune, Jörg, 13503 Berlin (DE); Klingbeil, Dimitrij, 13591 Berlin (DE); Schuhmann, Philipp, 14193 Berlin (DE); Jabs, Alexander, 16761 Hennigsdorf (DE)
(74) Vertreter: Siemens Patent Attorneys

(57) **Zusammenfassung**

Um einen Verbindungsleiter (2) zum elektrischen Anschluss eines ausgangsseitig Messignale bereitstellenden Sensors (6) an eine Intelligente elektronische Einheit (IED) (13), die zur Verarbeitung der Messsignale eingerichtet ist, mit
- wenigstens zwei elektrisch leitenden und voneinander isoliert angeordneten Leiterphasen (4a, 4b),
- einem Sensorende (9), an dem ein Leitereingang (10) zum elektrischen Verbinden mit einem Ausgang des Sensors (6) ausgebildet ist, und
- einem Auswerteeinheitsende (11), das einen Leiterausgang (12) zum elektrischen Verbinden mit einem Eingang der Auswerteeinheit (13) aufweist,
- wobei sich beide Leiterphasen (4a, 4b) vom Leitereingang (10) zum Leiterausgang (12) erstrecken und zum Übertragen der Messignale zwischen dem Ausgang des Sensors und dem Eingang der Auswertereinheit eingerichtet sind, zu schaffen, bei dem Messfehler durch hochfrequente Störungen vermieden sind wird vorgeschlagen, dass der Verbindungsleiter (1) auf einen Frequenzbereich angepasst ist, in dem die Störungen auftreten.

## Beschreibung

Die Erfindung betrifft einen Verbindungsleiter zum elektrischen Anschluss eines ausgangsseitig Messignale bereitstellenden Sensors an eine Intelligente elektronische Einheit (IED), die zur Verarbeitung der Messsignale eingerichtet ist, mit wenigstens zwei elektrisch leitenden und voneinander isoliert angeordneten Leitern, einem Sensorende, an dem ein Leitereingang zum elektrischen Verbinden mit einem Ausgang des Sensors ausgebildet ist, und einem Auswerteeinheitsende, das einen Leiterausgang zum elektrischen Verbinden mit einem Eingang der Auswerteeinheit aufweist, wobei sich beide Leiter vom Leitereingang zum Leiterausgang erstrecken und zum Übertragen der Messignale zwischen dem Ausgang des Sensors und dem Eingang der Auswertereinheit eingerichtet sind.

Die Erfindung betrifft ferner eine Anordnung für einen Einsatz im Bereich der Elektroenergieversorgung mit einem Sensor zum Erfassen einer elektrischen Größe an einer Leiterphase eines Elektroenergieversorgungsnetzes, einer Intelligenten Elektronischen Einheit (IED) und einem sich zwischen dem Sensor und der IED erstreckenden Verbindungsleiter.

Die Erfindung betriff darüber hinaus die Verwendung eines Verbindungsleiters zum Übertragen von Messignalen zwischen einem Stromsensor und einem IED.

Ein solcher Verbindungsleiter und eine solche Anordnung sind dem Fachmann aus der Praxis bekannt. So werden derzeit Verbindungskabel eingesetzt, um einen Sensor oder Sensorkopf, der ausgangsseitig analoge Strommesswerte bereitstellt mit einer intelligenten elektronischen Einheit, beispielsweise einer Merging Unit oder einem Schutzgerät zu verbinden. Dabei weist der Sensorkopf ein ringförmiges Messteil auf, das einen Phasenleiter eines mehrphasigen Leiters eines Elektroenergieversorgungsnetzes umschließt. Ein durch den Phasenleiter fließender Strom induziert dann in dem ringförmigen Messteil eine Spannung, die dem im Phasenleiter fließenden Strom entspricht. Nach einer Eichung des Sensors kann so der Strom im Phasenleiter gemessen werden.

Es hat sich jedoch herausgestellt, dass im Umfeld des Verbindungsleiters stattfindende Ereignisse, wie beispielsweis das Schalten eine Leistungsschalters, elektromagnetische Störungen erzeugen können, die die Messgenauigkeit des Sensorkopfes beeinträchtigen können.

Aufgabe der Erfindung ist es, Verbindungsleiter der eingangs genannten Art anzugeben, der gegenüber äußerer elektromagnetischer transienter Störstrahlung unempfindlich ist.

Diese Aufgabe wird ausgehend von dem oben genannten Verbindungsleiter erfindungsgemäß dadurch gelöst, dass der Verbindungsleiter auf einen Frequenzbereich angepasst ist, in dem die Störungen auftreten.

Im Rahmen der Erfindung wurde erkannt, dass solche transienten Störereignisse Wechselfelder - einer elektromagnetischen Strahlung - erzeugen, die im Bereich einer Hochfrequenz beispielsweise im Megaherzbereich liegen können. Ohne eine geeignete Anpassung des Verbindungsleiters auf diese Frequenzen verfälschen diese transienten Störfelder die Messergebnisse. Daher wird erfindungsgemäß vorgeschlagen, das Verbindungskabel auf diese Störfrequenzen anzupassen. Durch die Anpassung ist der Verbindungsleiter gegenüber den besagten hochfrequenten Störfeldern unempfindlich in dem Sinne, dass während der hochfrequenten Störung erfasste Messwerte zuverlässig erfasst werden können.

Zwar sind abgestimmte Verbindungskabel grundsätzlich aus dem Bereich der Hochfrequenz dem Fachmann bekannt. Die Erfindung schlägt jedoch vor, einen Verbindungsleiter, der für die Übertragung von Messwerten im Millisekundenbereich dient, auf die störenden Frequenzen im höher frequenten Bereich anzupassen. Derzeit werden zu diesem Zweck ausschließlich Verbindungsleiter eingesetzt, die nicht angepasst sind. Dies rührt daher, dass Elektroenergieversorgungsnetzte Wechselströme führen und Wechselspannungen aufweisen, deren Grundschwingungen bei 50 Herz oder 60 Herz liegen.

Die Anpassung erfolgt vorzugsweise mit Hilfe von Abschlusswiderständen. So kann jeder Phasenleiter (4a, 4b) über einen Abschlusswiderstand verfügen, wobei jeder Abschlusswiderstand am Sensorende angeordnet ist. Diese Art der Anpassung ist kostengünstig.

Vorteilhafterweise ist am Sensorende zwischen den Leiterphasen eine Kapazität ausgebildet. Da der Sensorkopf bezüglich der jeweiligen Phasen des Leiters der Elektroenergieversorgungsnetztes, den sein ringförmiges Messteil umschließt, ebenfalls eine Kapazität oder mit anderen Worten einen Kondensator ausbildet, ist gemäß dieser vorteilhaften Weiterentwicklung der Erfindung durch den zusätzlichen Kondensator oder mit anderen Worten der zusätzlichen Kapazität eine Reihenschaltung zweier Kondensatoren bereitgestellt. Diese Reihenschaltung kann auch als ein kapazitiver Spannungsteiler bezeichnet werden. Dabei ist eine der Leiterphasen des Verbindungsleiters mit einem Pol des ersten und des zweiten dem Sensor nachgeschalteten Kondensator verbunden. Die andere Leiterphase des erfindungsgemäßen ist vorzugsweise bei einem Gebrauch des Verbindungsleiters geerdet. Die andere Leiterphase ist mit anderen Worten erdbar oder mit anderen Worten auf Erdpotential legbar.

Vorteilhafterweise ist die Kapazität zwischen dem Leitereingang und den Abschlusswiderständen der Phasenleiter angeordnet. Es hat sich herausgestellt, dass diese elektrische Anordnung am zweckdienlichsten ist, um den Verbindungsleiter gegenüber hochfrequenten Störfeldern unempfindlich zu machen.

Gemäß einer weiteren Variante der vorliegenden Erfindung erstrecken sich die Phasenleiter in einer Kunststoffisolierung, so dass der Verbindungsleiter als Kabelleiter ausgebildet ist. Kabelleiter können einfach und schnell vor Ort verlegt oder angeschlossen werden.

Die Erfindung betrifft ferner eine Anordnung für einen Einsatz im Bereich der Elektroenergieversorgung mit einem Sensor zum Erfassen einer elektrischen Größe an einem Phasenleiter eines Elektroenergieversorgungsnetzes, einer Intelligenten Elektronischen Einheit (IED) und einem sich zwischen dem Sensor und der IED erstreckenden einem Verbindungsleiter, der wie oben beschrieben ausgestaltet ist. Das oben gesagte gilt für die erfindungsgemäße Anordnung entsprechend.

Schließlich betrifft die Erfindung auch die Verwendung eines Verbindungsleiters gemäß einem der vorhergehenden Ansprüche zum Übertragen zum Übertragen von Messignalen zwischen einem Stromsensor und einem IED. Abgestimmte oder mit Abschlusswiderständen ausgerüstete Verbindungsleiter sind aus dem Bereich der Hochfrequenztechnik grundsätzlich bekannt. Ihre Verwendung zwischen einem Sensor und einem IED zum Übertragen von analogen Messwerten wurde bislang jedoch nicht vorgeschlagen.

Gemäß einer diesbezüglichen Weiterentwicklung ist das IED ein Schutzgerät, eine Merging Unit oder eine PMU (was ist das genau?).

Die Erfindung wird nachfolgend anhand eines Ausführungsbeispielen näher erläutert, wobei gleiche Bezugszeichen auf gleich wirkende Bauteile verweisen und wobei die
- Figur 1: eine Ausführungsbeispiel einer Anordnung mit einem Verbindungskabel gemäß dem Stand der Technik,
- Figur 2: ein Ausführungsbeispiel der erfindungsgemäßen Verbindungskabels und
- Figur 3: ein Ausführungsbeispiel der erfindungsgemäßen Anordnung verdeutlichen.

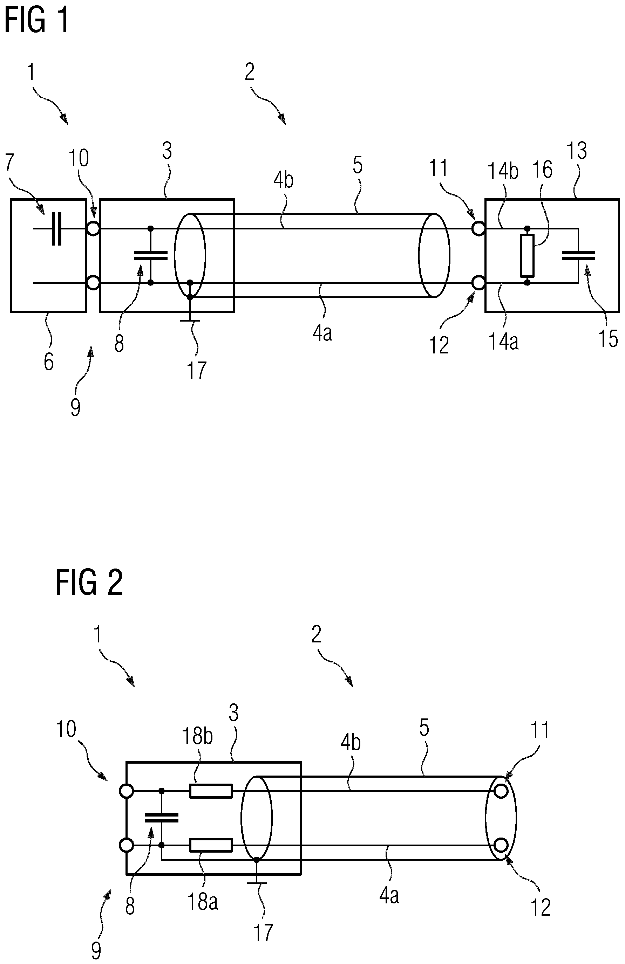

Figur 1 zeigt ein Ausführungsbeispiel einer Anordnung 1 gemäß dem Stand der Technik. Die besagte Anordnung 1 verfügt über einen Verbindungsleiter 2, der als Verbindungskabel 2 ausgestaltet ist. Das Verbindungskabel 2 umfasst einen Kabelstecker 3 sowie zwei Leiterphasen 4a und 4b, die elektrisch isoliert voneinander in einer Kunststoffummantelung 5 angeordnet sind. Die Kunststoffummantelung 5 umschließt die Leiterphasen 4a und 4b vollumfänglich. Das Bezugszeichen 17 deutet an, dass die Leiterphase 4a auf Erdpotential liegt. Diese Erdung kann über das IED erfolgen.

Der Kabelstecker 3 ist mit einem Sensor 6 verbunden, der einen ringförmigen Ringleiter aufweist, der in einer elektrischen Isolierung beispielsweise in einem mit Glasfasern befüllten Kunststoffgehäuse angeordnet ist. Der Sensor 6 ist zum Erfassen von Strömen eingerichtet, die durch einen Phasenleiter eines Elektroenergieversorgungsnetzes fließen. Dabei umschließt der Ringleiter des Sensors 6 einen der Phasenleiter des mehr- beispielsweise dreiphasigen Elektroenergieversorgungsnetztes. Da der Phasenleiter Wechselspannung führt, fließt durch die Kapazität zwischen dem Phasenleiter und dem metallischen Ringleiter des Sensors ein kleiner Wechselstrom. Dieser Strom ist der in der jeweiligen Phase des Energieversorgungsnetzes anliegenden Spannung proportional, sodass nach Eichung des Sensors 6 die besagte Spannung gemessen werden kann.

In der Figur 1 ist der Ringleiter des Sensorkopfes 6 schematisch durch einen Kondensator 7 dargestellt. Im Kabelstecker 3 ist ein weiterer Kondensator 8 erkennbar, der zwischen den Leiterphasen 4a und 4b des Verbindungskabels 2 angeordnet ist. Die Kondensatoren 7 und 8 sind in Reihe geschaltet und bilden einen kapazitiven Spannungsteiler aus. Durch zweckmäßige Wahl der Größe der Kondensatoren 7, 8 kann somit der gewünschten Spannungsbereich festgelegt werden, in dem die Messspannung zwischen den Leiterphasen 4a und 4b abgegriffen werden kann. Der Kondensator 8 ist in dem gezeigten Ausführungsbeispiel zwischen die Leiterphasen 4a und 4b gelötet. Die Leiterphase 4b ist mit jeweils einem Pol der beiden in Reihe geschalteten Kondensatoren verbunden. Der mit der Leiterphase 4a verbundene Pol des Kondensators 4a liegt auf einem Erdpotential, wie durch das Bezugszeichen 17 angedeutet ist.

An einem Sensorende 9 des Verbindungsleiters 2 bildet dieser einen Leitereingang 10 aus, der zum elektrischen Verbinden mit einem Ausgang des Sensorkopfes 6 ausgebildet ist. Der Leitereingang 10 ist beispielsweise durch mehrere starre senkrecht von einer nicht leitenden Gehäuseebene aufragende Verbindungsstifte ausgebildet, die in entsprechende Ösen des Sensorkopfes 6 einführbar sind.

An seinem von dem Sensor 6 abgewandten Ende, das im Folgenden als Auswerteeinheitsende 11 bezeichnet wird, bildet das Verbindungskabel 2 einen Leiterausgang 12 aus, der zur Verbindung mit einem Schutzgerät 13 dient. Das Schutzgerät 13 stellt eine von vielen Möglichkeiten der Ausgestaltung einer intelligenten elektronischen Einheit dar, die im Englischen als "intelligent electronic device" (IED) bezeichnet wird.

Es ist erkennbar, dass die Leiterphasen 4a und 4b des Verbindungskabels 2 in dem Schutzgerät 13 verlängert sind. Die sich in dem Schutzgerät 13 erstreckenden Verbindungsleiter sind mit den Bezugszeichen 14a und 14b versehen. Zwischen die Verbindungsleiter 14a und 14b ist ein Widerstand 16 geschaltet, der hier eine Größe von 2 MΩ (Megaohm) aufweist. Parallel zum Widerstand 16 ist eine Kapazität in Gestalt eines Kondensators 15 (30pF bis etwa 50pF) geschaltet. Der Kondensator 15 und der parallele Widerstand 16 sind durch die so genannte LowPowerInstrumentTransformer Normung vorgegeben. Technisch physikalisch bildet sich die Kapazität durch die reale Eingangsschaltung des IED aus. Der Wert entsteht zum Teil durch Leiterplattenkapazität und Halbleitereingangsimpedanz. Mit anderen Worten ergibt sich dieser Aufbau automatisch ohne diese entstandene Zusatzkapazität ist nicht die IED nicht realisierbar. Durch Verlängerung der Leiterphasen wird der besagte Widerstand am Auswerteeinheitsende zwischen den Leiterphasen 4a und 4b wirksam.

Wie bereits weiter oben ausgeführt wurde, haftet dem Verbindungsleiter 2 gemäß dem Stand der Technik und der mit ihm gebildeten Anordnung 1 gemäß dem Stand der Technik der Nachteil an, dass äußere hochfrequente Störungen die Messergebnisse beeinflussen können. Ein Beispiel für eine solche Störung ist das Schalten eines Leistungsschalters. Im Rahmen der Erfindung wurde erkannt, dass die hierbei entstehenden elektromagnetischen Felder eine Frequenz im Megaherzbereich aufweisen können. Durch diese hochfrequenten Störungen verursachte Messfehler können vermieden werden, wenn der Kabelleiter auf solche hochfrequenten Störungen abgestimmt ist. Figur 2 verdeutlicht ein solches erfindungsgemäßes Verbindungskabel 2.

Figur 2 zeigt ein Ausführungsbeispiel eines erfindungsgemäßen Verbindungsleiters 2, der wie in Figur 1 als Verbindungskabel 2 ausgestaltet ist. Das gezeigte erfindungsgemäße Verbindungskabel 2 weist die gleichen Komponenten auf, wie das Verbindungskabel 2 gemäß dem Stand der Technik, das in Figur 1 verdeutlicht ist. Die Erläuterungen zu Figur 1 gelten daher im Hinblick auf Figur 2 entsprechend, insofern sie das Verbindungskabel 2 betreffen.

Im Unterschied zu dem Verbindungskabel 2 gemäß Figur 1 verfügt das Verbindungskabel 2 gemäß Figur 2 jedoch über zwei Abschlusswiderstände 18a bzw. 18b die jeweils in einer der Leiterphasen 4a bzw. 4b angeordnet sind. Die Abschlusswiderstände 18a und 18b bilden in dem gezeigten Beispiel einen Widersand von 68 Ω auf, wobei die Wirksamkeit mit 10% größerem oder 10% kleinerem Wert auch gegeben ist. Das gezeigte Verbindungskabel 2 ist dadurch auf das Ableiten von Störungen und deren Umwandeln in Wärme im Bereich von ungefähr 3 bis weit über 30 MHz angepasst und optimiert. Aufgrund der Abschlusswiderstände 18a und 18b ist das Verbindungskabel 2 gemäß Figur 2 nicht mehr fehleranfällig gegenüber hochfrequenten Störungen, sodass die Messergebnisse nicht mehr verfälscht werden können.

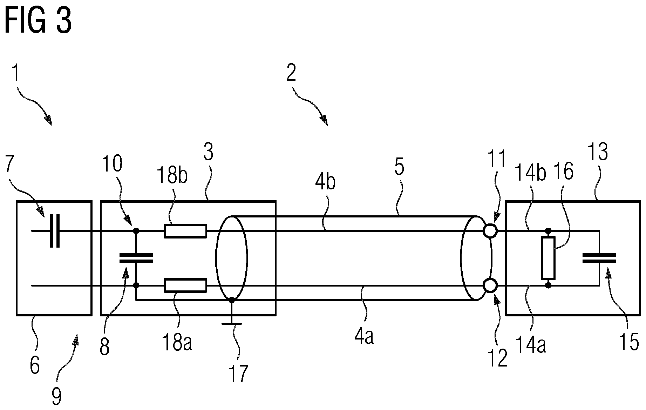

Figur 3 zeigt ein Ausführungsbeispiel der erfindungsgemäßen Anordnung 1 ebenfalls in einer schematischen Darstellung. Die Anordnung 1 gemäß Figur 3 entspricht im Wesentlichen der Darstellung des Standes der Technik gemäß Figur 1, wobei jedoch wieder die Abschlusswiderstände 18a und 18b in die Leiterphasen 4a bzw. 4b eingefügt sind. Die Abschlusswiderstände 1 weisen bei dem in Figur 3 gezeigten Ausführungsbeispiel einen Widerstand von 68 Ω entsprechend 18a und 18b auf. Das Verbindungskabel ist somit auf das breitbandige Ableiten von Störungen von etwa 1 bis ungefähr 50 MHz abgestimmt. Auf Grund dieser Abstimmung können die Messergebnisse durch hochfrequente Störungen nicht mehr verfälscht werden. Im Übrigen gelten die Ausführungen zu Figur 1 und 2 hier entsprechend.

## Patentansprüche

1. Verbindungsleiter (2) zum elektrischen Anschluss eines ausgangsseitig Messignale bereitstellenden Sensors (6) an eine Intelligente elektronische Einheit (IED) (13), die zur Verarbeitung der Messsignale eingerichtet ist, mit
- wenigstens zwei elektrisch leitenden und voneinander isoliert angeordneten Leiterphasen (4a, 4b),
- einem Sensorende (9), an dem ein Leitereingang (10) zum elektrischen Verbinden mit einem Ausgang des Sensors (6) ausgebildet ist, und
- einem Auswerteeinheitsende (11), das einen Leiterausgang (12) zum elektrischen Verbinden mit einem Eingang der Auswerteeinheit (13) aufweist,
- wobei sich beide Leiterphasen (4a, 4b) vom Leitereingang (10) zum Leiterausgang (12) erstrecken und zum Übertragen der Messignale zwischen dem Ausgang des Sensors und dem Eingang der Auswertereinheit eingerichtet sind,
**dadurch gekennzeichnet, dass**
der Verbindungsleiter (1) auf einen Frequenzbereich angepasst ist, in dem die Störungen auftreten.

2. Verbindungsleiter (2) nach Anspruch 1,
**dadurch gekennzeichnet, dass**
jeder Phasenleiter (4a, 4b) über einen Abschlusswiderstand (18a, 18b) verfügt, wobei jeder Abschlusswiderstand (18a, 18b) am Sensorende (9) angeordnet ist.

3. Verbindungsleiter (2) nach Anspruch 2,
**dadurch gekennzeichnet, dass**
am Sensorende (9) zwischen den Leiterphasen (4a,4b) eine Kapazität (8) ausgebildet ist.

4. Verbindungsleiter (2) nach Anspruch 3,
**dadurch gekennzeichnet, dass**
die Kapazität (8) zwischen dem Leitereingang (10) und den Abschlusswiderständen (18a, 18b) der Leiterphasen (4a, 4b) angeordnet ist.

5. Verbindungsleiter (2) nach einem der vorhergehenden Ansprüche,
**dadurch gekennzeichnet, dass**
die Phasenleiter (2) sich in einer Kunststoffummantelung (5) erstrecken, so dass der Verbindungsleiter als Verbindungskabel (2) ausgestaltet ist.

6. Verbindungsleiter (2) nach einem der vorhergehenden Ansprüche,
**dadurch gekennzeichnet, dass**
am Auswerteeinheitsende ein Widerstand zwischen der Leiterphasen wirksam ist.

7. Anordnung (1) für einen Einsatz im Bereich der Elektroenergieversorgung mit
- einem Sensor zum Erfassen einer elektrischen Größe an einer Leiterphase eines Elektroenergieversorgungsnetzes, einer Intelligenten Elektronischen Einheit (IED) und einem sich zwischen dem Sensor und der IED erstreckenden einem Verbindungsleiter gemäß einem der vorhergehenden Ansprüche.

8. Verwendung eines Verbindungsleiters (2) gemäß einem der Ansprüche 1 bis 6 zum fehlerfreien Übertragen von Messignalen zwischen einem Sensor (6) und einem IED (13).

9. Verwendung eines Verbindungsleiters (2) gemäß einem der Ansprüche 1 bis 6 zum fehlerfreien Übertragen von Messignalen zwischen einem Sensor (6) und einem Schutzgerät (13) .
